Europäisches Patentamt

European Patent Office

Office européen des brevets

(19)

(11) Veröffentlichungsnummer: **0 006 241**
**B1**

(12) **EUROPÄISCHE PATENTSCHRIFT**

(45) Veröffentlichungstag der Patentschrift: **23.12.81**

(21) Anmeldenummer: **79102012.6**

(22) Anmeldetag: **18.06.79**

(51) Int. Cl.³: **H 01 L 23/46, H 05 K 7/20**

(54) Kühlkörper für elektrische Bauelemente.

(30) Priorität: **19.06.78 DE 2826898**

(43) Veröffentlichungstag der Anmeldung:
**09.01.80 Patentblatt 80/1**

(45) Bekanntmachung des Hinweises auf die Patenterteilung:
**23.12.81 Patentblatt 81/51**

(84) Benannte Vertragsstaaten:
**FR GB SE**

(56) Entgegenhaltungen:
**DE - B - 2 160 302**
**DE - A - 2 814 809**
**FR - A - 2 378 250**

(73) Patentinhaber: **SIEMENS AKTIENGESELLSCHAFT**
**Berlin und München**
**Postfach 22 02 61**
**D-8000 München 22 (DE)**

(72) Erfinder: **Bahlinger, Walter**
**Eduard-Schenkstrasse 68**
**D-8000 München 40 (DE)**

Courier Press, Leamington Spa, England.

Kühlkörper für elecktrische Bauelemente

Die Erfindung bezieht sich auf Kühlkörper für elektrische Bauelemente, mit einem mit mindestens einer Ausnehmung versehenen Metallkörper, mindestens einem im Inneren angeordneten Kühlmittelkanal und mindestens einem mit dem Kühlmittelkanal in Verbindung stehenden Zufluß und Abfluß.

Ein solcher bekannter Kühlkörper besteht beispielsweise aus einem Metallblock, der mit einer Ringnut versehen ist. Diese ist mit einem Zufluß und einem Abfluß verbunden. Die Ringnut bildet einen Kühlmittelkanal, über den ein großer Teil der durch das elektrische Bauelement erzeugten Verlustwärme abgeführt wird. Der Kühlmittelkanal wird mittels einer Metallplatte verschlossen, die mit dem Metallblock verlötet wird. Beim Verlöten kann Lot in den Kühlkanal gelangen, was zur Korrosion führen kann. Besteht der Metallkörper zum Beispiel aus Kupfer, so kann dieser außerdem durch die beim Löten angewandte Temperatur weich werden und sich verformen. Besteht der Metallkörper aus Aluminium, so ist ein Abdichten der Öffnung durch Verlöten überhaupt nicht möglich.

Bei einem weiteren bekannten Kühlkörper besteht der Metallkörper aus zwei Teilen. Diese weisen jeweils Ausnehmungen auf, die so ausgebildet sind, daß sich beim Zusammenfügen der Teile ein mäanderförmiger Kühlmittelkanal ergibt. Die beiden Teile werden miteinander verschraubt. Eine Verschraubung erlaubt jedoch nur eine begrenzte Anzahl von konstruktiven Lösungen. Außerdem sind im allgemeinen elastische Dichtungen erforderlich. Der Wärmeübergang und der elektrische Kontakt ist darüber hinaus bei verschraubten Teilen nicht optimal.

Der Erfindung liegt die Aufgabe zugrunde, einen Kühlkörper der eingangs erwähnten Art anzugeben, bei dem weder eine Verschraubung noch eine stoffschlüssige Verbindung zum Beispiel durch Verlöten erforderlich ist.

Die Erfindung ist gekennzeichnet durch einen in die Ausnehmung eingesetzten, mit dem Metallkörper durch einen Schrumpfsitz verbundenen metallenen Kern, der mindestens eine mit dem Zu- und Abfluß in Verbindung stehende Aussparung aufweist, die zusammen mit mindestens einer Wand der Ausnehmung des Metallkörpers den Kühlmittelkanal bildet.

Weiterbildungen dieses Kühlkörpers sind Gegenstand der Unteransprüche.

Die Erfindung wird an Hand dreier Ausführungsbeispiele in Verbindung mit den Fig. 1 bis 7 näher erläutert.

Es zeigen:

Fig. 1, 2 ein erstes Ausführungsbeispiel im Schnitt und in der Aufsicht,

Fig. 3, 4 ein zweites Ausführungsbeispiel im Schnitt und in der Aufsicht,

Fig. 5, 6 und 7 ein drittes Ausführungsbeispiel im Querschnitt, in der Aufsicht und im Längsschnitt.

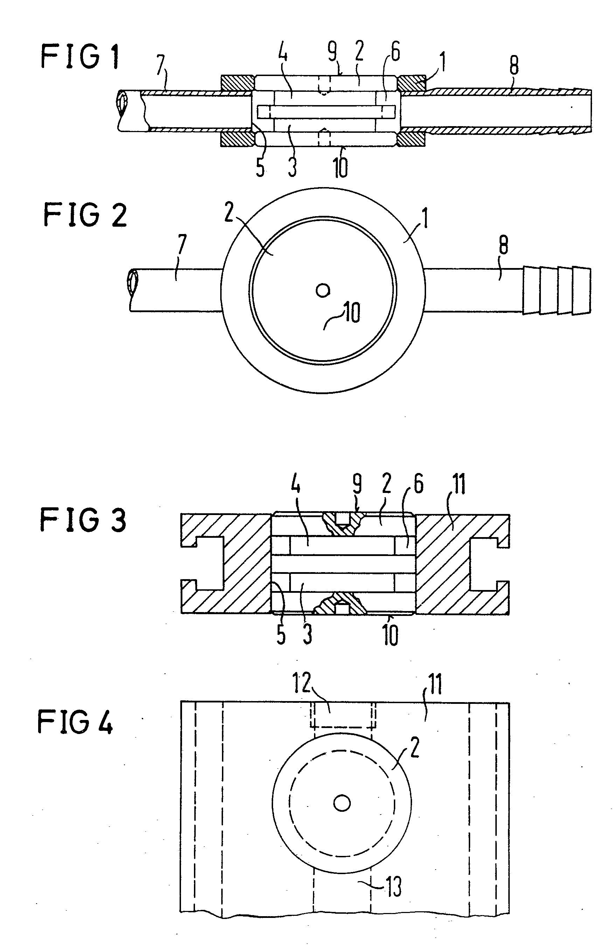

In den Fig. 1 und 2 ist der Metallkörper des Kühlkörpers mit 1 bezeichnet. Er hat die Form eines Rings und kann zum Beispiel aus Stahl bestehen. Der Ring hat eine Ausnehmung 6, in der ein metallener Kern 2 sitzt. Dieser kann beispielsweise aus Kupfer bestehen. Der Kern 2 hat zwei den Kern in Umfangsrichtung umgebende Nuten 3, 4. Diese Nuten bilden zusammen mit einer Wand 5 des Metallkörpers 1 einen Kühlmittelkanal. Dieser Kühlmittelkanal steht mit einem Zufluß 7 und einem Abfluß 8 in Verbindung. Der Kern 2 ist mit dem Metallkörper 1 durch einen Schrumpfsitz verbunden. Dieser Schrumpfsitz, der an sich bekannt ist, wird durch Erhitzen des Metallkörpers 1 und/oder Abkühlen des Kerns 2 auf eine Temperatur erreicht, die ein leichtes Zusammenstecken beider Teile ermöglicht. Nach Abkühlen des Metallkörpers 1 und/oder Erwärmen des Kerns 2 kommt eine dichte Verbindung zwischen den genannten Teilen zustande. Die Ausnehmung 6 des Metallkörpers 1 wird damit gegen einen Austritt des Kühlmediums abgedichtet.

Der Kern 2 kann an einer oder beiden Stirnseiten mit Sitzflächen 9, 10 versehen sein, die zur Kontaktierung zum Beispiel eines Halbleiterbauelementes mit scheibenförmigem Gehäuse geeignet ist. Zur Lagesicherung dieser Halbleiterbauelemente kann der Kern Bohrungen aufweisen, in die mit dem Gehäuse des Halbleiterbauelements verbundene Stifte eingreifen.

Der Kühlkörper nach den Fig. 3, 4 unterscheidet sich von dem in Fig. 1, 2 gezeigten im wesentlichen dadurch, daß der Metallkörper 11 Rechteckform hat. Er kann beispielsweise aus stranggepreßtem Aluminium bestehen. In Fig. 4 ist der Metallkörper nur mit einem Kern 2 dargestellt. Es ist jedoch möglich, in einem Metallkörper 11 mehrere, zum Beispiel drei nebeneinanderliegende Kerne vorzusehen. Diese Kerne sind durch Bohrungen 12, 13, die als Zu- und Abflüsse dienen, miteinander verbunden und werden nacheinander vom Kühlmittelstrom umspült. Die Bohrungen 12, 13 können beim Strangpressen des Metallkörpers 11 mit hergestellt werden.

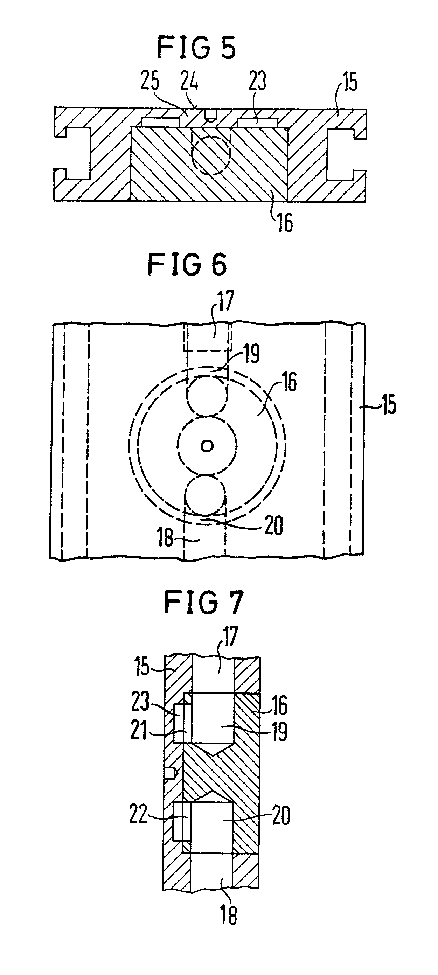

Bei den Ausführungsbeispielen nach den Fig. 1 bis 4 wird die Kühlung durch Umspülen des Kerns erreicht. Beim Ausführungsbeispiel nach den Fig. 5, 6 und 7 wird von dem Prinzip der Aufprallkühlung Gebrauch gemacht. Dieses Ausführungsbeispiel unterscheidet sich von den bisher beschriebenen im wesentlichen dadurch, daß der Kühlmittelstrom, der in einen Zufluß 17 in den Metallkörper 15 hineinfließt, in einem Kern 16 um 90° umgelenkt wird und gegen eine Wand 25 des Metallkörpers 15 prallt. Dies geschieht durch in radialer Richtung im Kern 16 angeordnete Aussparungen 19, 20, die über axiale Aussparungen 21, 22 und eine in der Wand 25 angeordnete Ringnut 23 miteinander verbunden sind. Die Wand 25 ist als Sitzfläche 24 zum Beispiel für ein Leistungs-Halbleiterbauelement ausgebildet. Der Kern 16 ist wiederum in den Metallkörper 15 eingeschrumpft. Auch hier kann der Metallkörper 15 ein Strangpreßprofil aus Aluminium sein und der Kern 16 aus Kupfer bestehen.

Bei diesem Ausführungsbeispiel ist im Gegensatz zu dem Ausführungsbeispeil nach Fig. 1 bis 4 die vom Kern 16 verschlossene Ausnehmung im Metallkörper 15 nicht durchgehend. Der Vorteil der besseren Kühlung muß hier mit dem Nachteil einer etwas aufwendigeren Fertigung erkauft werden.

Bei Metallkörpern aus Aluminium und Kupferkernen läßt sich ein einwandfreier Schrumpfsitzt und damit eine einwandfreie Abdichtung zum Beispiel wie folgt erzielen: Die Bohrung im Metallkörper betrage zum Beispiel 48 mm mit einer Toleranz von + 25 $\mu$m. Der Kern weist gegenüber der Bohrung ein Übermaß von +136 $\mu$m bis + 175 $\mu$m auf. Wird der Metallkörper auf 260°C erwärmt, so läßt sich der Kupferkern leicht in die Öffnung einführen und sitzt nach dem Erkalten des Metallkörpers einwandfrei fest. Der thermische und elektrische Kontakt zwischen Kern und Metallkörper ist optimal.

**Patentansprüche**

1. Kühlkörper für elektrische Bauelemente, mit einem mit mindestens einer Ausnehmung versehenen Metallkörper, mindestens einem im Inneren angeordneten Kühlmittelkanal und mindestens einem mit dem Kühlmittelkanal in Verbindung stehenden Zufluß und Abfluß, gekennzeichnet durch einen in die Ausnehmung (6) eingesetzten, mit dem Metallkörper (1) durch einen Schrumpfsitz verbundenen metallenen Kern (2), der mindestens eine mit dem Zu- und Abfluß (7, 8) in Verbindung stehende Aussparung (3, 4) aufweist, die zusammen mit Mindestens einer Wand (5) der Ausnehmung (6) des Metallkörpers (1) den Kühlmittelkanal bildet.

2. Kühlkörper nach Anspruch 1, dadurch gekennzeichnet, daß die Ausnehmung (6) und der Kern (2) zylindrisch ausgebildet sind und daß die Aussparung des Kerns eine den Kern in Umfangrichtung umgebenden Nut (2, 3) ist.

3. Kühlkörper nach Anspruch 1 oder 2, dadurch gekennzeichnet, daß die Ausnehmung (6) im Metallkörper (1, 11) durchgehend und an beiden Enden durch den Kern (2) verschlossen ist.

4. Kühlkörper nach Anspruch 1 oder 2, dadurch gekennzeichnet, daß die Ausnehmung im Metallkörper (15) nicht durchgehend und am äußeren Ende durch den Kern (16) verschlossen ist.

5. Kühlkörper nach Anspruch 1, dadurch gekennzeichnet, daß die Ausnehmung und der Kern (16) zylindrisch ausgebildet sind, daß die Ausnehmung im Metallkörper (15) nicht durchgehend ist, daß der Kern mit radialen Aussparungen (19, 20) versehen ist, die jeweils mit einer axial gerichteten Aussparung (21, 22) im Kern verbunden sind, und daß die Wand des inneren Endes der Ausnehmung im Metallkörper (15) mindestens eine Nut (23) aufweist, die mit den axialen Aussparungen (21, 22) im Kern verbunden ist.

6. Kühlkörper nach einem der Ansprüche 1 bis 5, dadurch gekennzeichnet, daß der Metallkörper (11, 15) mehrere nebeneinanderliegende Ausnehmungen aufweist, die untereinander durch Zu- und Abflüsse (17, 18) verbunden sind.

7. Kühlkörper nach Anspruch 6, dadurch gekennzeichnet, daß der Metallkörper (11, 15) aus einem Strangpreßprofil besteht.

8. Kühlkorper nach einem der Ansprüche 1 bis 7, dadurch gekennzeichnet, daß der Metallkörper (11, 15) aus Aluminium und der Kern (2, 16) aus Kupfer besteht.

9. Kühlkörper nach einem der Ansprüche 1 bis 8 dadurch gekennzeichnet, daß der Kern mindestens eine Sitzfläche (9, 10) für ein Halbleiterbauelement aufweist.

10. Kühlkörper nach Anspruch 5 oder 6, dadurch gekennzeichnet, daß der Metallkörper an der der nichtdurchgehenden Ausnehmung gegenüberliegenden Seite eine Sitzfläche (24) für ein Halbleiterbauelement aufweist.

**Claims**

1. A cooling element for electrical components, comprising a metal body which is provided with at least one hole therein, at least one coolant channel which is arranged within the body, and at least one inlet and outlet connected to the coolant channel, characterised by a metal core (2) which is inserted into the recess (6) and connected to the metal body (1) by shrink fitting, and which has at least one opening therein (3, 4) which is connected to the inlet and the outlet (7, 8) and, together with at least one wall (5) of the hole (6) in the metal body (1), forms the coolant channel.

2. A cooling element as claimed in Claim 1, characterised in that the hole (6) and the core (2) are cylindrical in shape and that the opening in the core is in the form of a groove (2, 3) which surrounds the core in the peripheral direction.

3. A cooling element as claimed in Claim 1 or 2, characterised in that the hole (6) in the metal body (1, 11) passes through it and is closed by the core (2) at both ends.

4. A cooling element as claimed in Claim 1 or 2, characterised in that the hole in the metal body (15) does not pass through the body and is closed by the core (16) at its outer end.

5. A cooling element as claimed in Claim 1, characterised in that the hole and the core (16) are cylindrical in shape, that the hole in the metal body (15) does not pass through it, that the core is provided with radial openings (19, 20) which are each connected to an axially directed opening (21, 22) in the core, and that the wall of the inner end of the hole in the metal body (15) has at least one groove (23) therein, which is connected with the axial openings (21, 22) in the core.

6. A cooling element as claimed in one of Claims 1 to 5, characterised in that the metal body (11, 15) has a plurality of holes which are positioned beside one another and which are connected to one another by inlets and outlets (17, 18).

7. A cooling element as claimed in Claim 6, characterised in that the metal body (11, 15) consists of an extruded section.

8. A cooling element as claimed in one of Claims 1 to 7, characterised in that the metal body (11, 15) consists of aluminium and the core (2, 16) consists of copper.

9. A cooling element as claimed in one of Claims 1 to 8, characterised in that the core has at least one seating (9, 10) for a semiconductor component.

10. A cooling element as claimed in Claim 5 or 6, characterised in that the metal body has a seating (24) for a semiconductor component on the side opposite the hole which does not pass through the body.

## Revendications

1. Radiateur pour composants électriques, du type comportant un corps métallique pourvu d'au moins une ouverture, au moins un canal disposé á l'intérieur et destiné à un milieu de refroidissement et au moins une adduction et une évacuation reliées audit canal, caractérisé par un noyau métallique (2) monté dans l'ouverture (6) et relié au corps métallique (1) par retrait, ledit noyau métallique (2) comportant au moins un évidement (3, 4) relié à l'adduction et à l'évacuation (7, 8) et formant avec au moins une paroi (5) de l'ouverture (6) du corps métallique (1) le canal d'écoulement pour le milieu de refroidissement.

2. Radiateur selon la revendication 1, caractérisé par le fait que l'ouverture (6) et le noyau (2) sont de forme cylindrique et que l'évidement du noyau est constitué par une gorge (2, 3) entourant le noyau dans la direction périphérique.

3. Radiateur selon la revendication 1 ou 2, caractérisé par le fait que l'ouverture (6) dans le corps métallique (1, 11) est une ouverture traversante qui est obturée à ses deux extrémités par le noyau (2).

4. Radiateur selon la revendication 1 ou 2, caractérisé par le fait que l'ouverture dans le corps métallique (15) n'est pas traversante et elle est obturée à ses deux extrémités par le noyau (16).

5. Radiateur selon la revendication 1, caractérisé par le fait que l'ouverture et le noyau (16) sont de forme cylindrique, que l'ouverture dans le corps métallique (15) n'est pas traversante, que le noyau est pourvu d'évidements radiaux (19, 20) qui sont respectivement reliés avec un évidement radial (21, 22) ménagé dans le noyau, et que la paroi de l'extrémité intérieure de l'ouverture ménagée dans le corps métallique (15) comporte au moins une gorge (23) qui est reliée avec les évidements axiaux (21, 22) ménagés dans le noyau.

6. Radiateur selon l'une des revendications 1 à 5, caractérisé par le fait que le corps métallique (11, 15) comporte plusieurs ouvertures disposées les unes à côté des autres et qui sont reliées entre elles par des adductions et des évacuations (17, 18).

7. Radiateur selon la revendication 6, caractérisé par le fait que le corps métallique (11, 15) est constitué par un profilé extrudé.

8. Radiateur selon l'une des revendications 1 à 7, caractérisé par le fait que le corps métallique (11, 15) est constitué par de l'aluminium et le noyau (2, 16) est constitué par du cuivre.

9. Radiateur selon l'une des revendications 1 à 8, caractérisé par le fait que le noyau possède au moins une surface d'appui (9, 10) pour un composant à semiconducteurs.

10. Radiateur selon la revendication 5 ou 6, caractérisé par le fait que le corps métallique présente, sur le côté qui est opposé à l'ouverture non traversante, une surface d'appui (29) pour un composant à semiconducteurs.

FIG 1

FIG 2

FIG 3

FIG 4

## FIG 5

25  24  23  15

16

## FIG 6

17

19

16

15

18  20

## FIG 7

15  17

23  16

21  19

22  20

18